# EUROPEAN PATENT APPLICATION

(11) **EP 4 617 774 A1**
(43) Date of publication of application: **17.09.2025**
(21) Application number: 23888529.7
(22) Date of filing: 27.10.2023
(51) Int. Cl.: G03F 7/004, C08F 2/44, C08F 290/00, G02B 5/20, G03F 7/075

(54) **PHOTOSENSITIVE RESIN COMPOSITION, PHOTOSENSITIVE RESIN COATING FILM, PATTERN FORMATION METHOD, AND LIGHT EMITTING ELEMENT**

(30) Priority: 11.11.2022 JP 2022181148
(71) Applicant: SHIN-ETSU CHEMICAL CO., LTD., Tokyo 1000005 (JP)
(72) Inventor: MARUYAMA, Hitoshi, Annaka-shi, Gunma 379-0224 (JP); NOJIMA, Yoshihiro, Annaka-shi, Gunma 379-0195 (JP); AOKI, Shinji, Annaka-shi, Gunma 379-0195 (JP); TOBISHIMA, Kazuya, Annaka-shi, Gunma 379-0195 (JP)
(74) Representative: Schicker, Silvia
(86) International application number: PCT/JP2023/038850
(87) International publication number: WO 2024/101181

(57) **Abstract**

The present invention is a photosensitive resin composition including: (A) a (meth)acryloyl group-containing resin; (B) a photo-radical generator; and (C) a polymer in which a quantum dot having a silane coupling agent coordinated is copolymerized with alkoxysilane, alkoxysilane hydrolysate, or condensate thereof. This can provide: a photosensitive resin composition capable of easily forming a film having high lithography resolution and favorable luminous properties; a photosensitive resin film obtained by using the photosensitive resin composition; patterning processes using these; and a light emitting device including a cured film obtained by using the photosensitive resin film.

## Description

### TECHNICAL FIELD

The present invention relates to: a photosensitive resin composition; and a photosensitive resin film, a patterning process, and a light emitting device, which utilize the photosensitive resin composition.

### BACKGROUND ART

Various methods have been proposed to form displays containing red, green, and blue subpixels. As one of the methods, there is a method in which light from an LED array is converted through a color conversion structure such that blue light having a shorter wavelength to red and green light having longer wavelengths. Quantum dots have been employed for this color conversion.

Recently, such LED arrays are fabricated in micro size, and micro-LED displays using these have drawn attention. Although methods of forming a color conversion structure on an LED array include a lithography process using a photosensitive material (Patent Document 1), further miniaturization has been demanded recently to be used for a small display. In addition, there are high demands for luminous properties from the viewpoint of display clearness.

### CITATION LIST

### PATENT LITERATURE

Patent Document 1: JP2021-089347A NON PATENT LITERATURE

Non Patent Document 1: Journal of Photopolymer Science and Technology, Vol 23, 2010, p115-119

### SUMMARY OF INVENTION

### TECHNICAL PROBLEM

The present invention has been made in view of the above circumstances. An object of the present invention is to provide: a photosensitive resin composition capable of easily forming a film having high lithography resolution and favorable luminous properties; a photosensitive resin film obtained by using the photosensitive resin composition; patterning processes using these; and a light emitting device including a cured film obtained by using the photosensitive resin film.

### SOLUTION TO PROBLEM

To solve the above problems, the present invention provides a photosensitive resin composition comprising:
(A) a (meth)acryloyl group-containing resin;
(B) a photo-radical generator; and
(C) a polymer in which a quantum dot having a silane coupling agent coordinated is copolymerized with alkoxysilane, alkoxysilane hydrolysate, or condensate thereof.

Such a photosensitive resin composition can easily form a film having high lithography resolution and favorable luminous properties.

Further, in the present invention, the component (C) preferably has a skeleton having a radically reactive functional group in a surface coating layer of the quantum dot.

Such a photosensitive resin composition can prevent the quantum dot from escaping in developing and can impart high luminous properties to a pattern.

Further, in the present invention, the component (C) preferably has any one or more kinds of an amino group, a thiol group, a carboxy group, a phosphino group, a phosphine oxide group, or an ammonium ion, as a ligand substituent of the silane coupling agent.

Such a photosensitive resin composition has higher lithography resolution.

Further, in the present invention, the component (C) is preferably contained in 5 to 80 mass% of the photosensitive resin composition.

Such a photosensitive resin composition can form a fine pattern while keeping favorable luminous properties.

Further, in the present invention, the component (A) preferably has a double bond equivalent of 240 to 1,000 g/mol.

Such a photosensitive resin composition has high crosslinking density and can form a pattern with a good shape after development.

Further, in the present invention, the component (A) is preferably an acrylic resin having a weight-average molecular weight of 5,000 to 100,000 g/mol.

Such a photosensitive resin composition makes it difficult to cause a decrease in a film quantity of an exposed portion when developed and has a good solubility of an unexposed portion.

Further, in the present invention, the photosensitive resin composition preferably further comprises (D) a surfactant.

Such a photosensitive resin composition can improve coatability.

Further, in the present invention, the photosensitive resin composition preferably further comprises (E) a silane coupling agent.

Such a photosensitive resin composition can improve adhesiveness to a substrate.

Further, in the present invention, the photosensitive resin composition preferably further comprises a crosslinking agent (F) having 2 or more functions of (meth)acryloyl groups.

By using such a photosensitive resin composition, the obtained cured film has high reliability.

Further, in the present invention, the photosensitive resin composition preferably further comprises (G) a solvent.

Such a photosensitive resin composition can improve coatability.

Further, the present invention provides a photosensitive resin film comprising a dried product of the photosensitive resin composition described above.

Such a photosensitive resin film has a high lithography resolution and favorable luminous properties.

Further, the present invention provides a patterning process comprising steps of:
(i) applying the photosensitive resin composition described above onto a substrate to form a photosensitive resin film on the substrate;
(ii) exposing the photosensitive resin film to light; and
(iii) developing the exposed photosensitive resin film with a developer to dissolve and remove an unexposed portion, thereby to form a pattern.

By such a patterning process, it is possible to form a pattern with high lithography resolution and obtain a pattern of a film having favorable luminous properties.

Further, the present invention provides a light emitting device comprising a cured film having a pattern formed in the photosensitive resin film described above.

Such a light emitting device has high lithography resolution and favorable luminous properties.

### ADVANTAGEOUS EFFECTS OF INVENTION

The inventive photosensitive resin composition can easily form a film having high resolution and favorable luminous properties thanks to containing a (meth)acryloyl group-containing resin, a photo-radical generator, and a polymer in which a quantum dot having a silane coupling agent coordinated is copolymerized with alkoxysilane, alkoxysilane hydrolysate, or condensate thereof, and therefore is suitable for a light emitting device.

### DESCRIPTION OF EMBODIMENTS

As described above, it has been desired to develop a photosensitive resin composition capable of easily forming a film having high lithography resolution and favorable luminous properties; a photosensitive resin film obtained by using the photosensitive resin composition; patterning processes using these; and a light emitting device including a cured film obtained by using the photosensitive resin film.

To achieve the object, the present inventors have earnestly studied and found out that a photosensitive resin composition containing a (meth)acryloyl group-containing resin (A), a photo-radical generator (B), and a polymer (C) in which a quantum dot having a silane coupling agent coordinated was copolymerized with alkoxysilane, alkoxysilane hydrolysate, or condensate thereof, could easily form a film (a photosensitive resin film) having high lithography resolution and favorable luminous properties, and have completed the present invention.

That is, the present invention provides a photosensitive resin composition comprising:
(A) a (meth)acryloyl group-containing resin;
(B) a photo-radical generator; and
(C) a polymer in which a quantum dot having a silane coupling agent coordinated is copolymerized with alkoxysilane, alkoxysilane hydrolysate, or condensate thereof.

Hereinafter, the present invention will be described in detail, but the present invention is not limited thereto.

### [Photosensitive Resin Composition]

The inventive photosensitive resin composition contains a (meth)acryloyl group-containing resin (A), a photo-radical generator (B), and a polymer (C) in which a quantum dot having a silane coupling agent coordinated is copolymerized with alkoxysilane, alkoxysilane hydrolysate, or condensate thereof. As necessary, the inventive photosensitive resin composition may further contain other components, such as a surfactant (D), a silane coupling agent (E), a crosslinking agent (F) having 2 or more functions of (meth)acryloyl groups, and a solvent (G). Hereinbelow, each component constituting the photosensitive resin composition will be described.

### [(A) (Meth)acryloyl Group-Containing Resin]

The (meth)acryloyl group-containing resin (A) to be used in the present invention is not particularly limited as long as it has a (meth)acryloyl group.

In the present invention, the (meth)acryloyl group-containing resin (A) is preferably an acrylic resin having a weight-average molecular weight in the range of 5,000 to 100,000 g/mol, more preferably in the range of 10,000 to 50,000 g/mol. When the weight-average molecular weight of the (meth)acryloyl group-containing resin (A) is within the above range, it difficult to cause a decrease in a film quantity of an exposed portion when developed and an unexposed portion has a good solubility. In addition, acrylic resin is transparent and colorless, and thus suitable for display applications. The acrylic resin referred to here is a polymer of acrylic acid ester or methacrylic acid ester. The weight-average molecular weight is a value determined as a weight-average molecular weight (weight-average degree of polymerization) in terms of polystyrene according to gel permeation chromatography (GPC) using toluene as a developing solvent.

In the present invention, the (meth)acryloyl group-containing resin (A) preferably has a double bond equivalent in the range of 240 to 1,000 g/mol, more preferably in the range of 240 to 700 g/mol. Incidentally, the double bond equivalent is the weight of the resin per (meth)acryloyl group. When the double bond equivalent of the (meth)acryloyl group-containing resin (A) is within the above range, it is possible to form a pattern with high crosslinking density and a good shape after development.

In the present invention, the (meth)acryloyl group-containing resin (A) preferably has an acid value in the range of 0 to 150 mgKOH/g. When the acid value is less than 30 mgKOH/g, the solubility in an alkaline developer is low, making development with an organic solvent suitable. When the acid value is 150 mgKOH/g or less, the pattern will not peel off during alkaline development.

In the present invention, one of the (meth)acryloyl group-containing resins (A) may be used, or two or more kinds thereof may be used in combination. The (meth)acryloyl group-containing resin (A) is preferably in the range of 10 to 90 mass%, more preferably in the range of 15 to 85 mass% relative to the total amount of the photosensitive resin composition.

### [(B) Photo-Radical Generator]

The photo-radical generator used in the present invention is not particularly limited. Examples thereof include acetophenone compounds, benzophenone compounds, thioxanthone compounds, benzoin compounds, triazine compounds, and oxime compounds.

Examples of acetophenone compounds include 2,2'-diethoxyacetophenone, 2,2'-dibutoxyacetophenone, 2-hydroxy-2-methylpropiophenone, p-t-butyltrichloroacetophenone, p-t-butyldichloroacetophenone, 4-chloroacetophenone, 2,2'-dichloro-4-phenoxyacetophenone, 2-methyl-1-(4-(methylthio)phenyl)-2-morpholinopropan-1-one, and 2-benzyl-2-dimethylamino-1-(4-morpholinophenyl)-butan-1-one.

Examples of benzophenone compounds include benzophenone, benzoylbenzoic acid, methyl benzoylbenzoate, 4-phenylbenzophenone, hydroxybenzophenone, acrylated benzophenone, 4,4'-bis(dimethylamino)benzophenone, 4,4'-bis(diethylamino)benzophenone, 4,4'-dimethylaminobenzophenone, 4,4'-dichlorobenzophenone, and 3,3'-dimethyl-2-methoxybenzophenone.

Examples of the thioxanthone compounds include thioxanthone, 2-methylthioxanthone, isopropylthioxanthone, 2,4-diethylthioxanthone, 2,4-diisopropylthioxanthone, and 2-chlorothioxanthone.

Examples of the benzoin compounds include benzoin, benzoin methyl ether, benzoin ethyl ether, benzoin isopropyl ether, benzoin isobutyl ether, and benzyl dimethyl ketal.

Examples of triazine compounds include 2,4,6-trichloro-s-triazine, 2-phenyl-4,6-bis(trichloromethyl)-s-triazine, 2-(3',4'-dimethoxystyryl)-4,6-bis(trichloromethyl)-s-triazine, 2-(4'-methoxynaphthyl)-4,6-bis(trichloromethyl)-s-triazine, 2-(p-methoxyphenyl)-4,6-bis(trichloromethyl)-s-triazine, 2-(p-tolyl)-4,6-bis(trichloromethyl)-s-triazine, 2-biphenyl-4,6-bis(trichloromethyl)-s-triazine, bis(trichloromethyl)-6-styryl-s-triazine, 2-(naphth-1-yl)-4,6-bis(trichloromethyl)-s-triazine, 2-(4-methoxynaphth-1-yl)-4,6-bis(trichloromethyl)-s-triazine, 2,4-bis(trichloromethyl)-6-piperonyl-s-triazine, and 2,4-bis(trichloromethyl)-6-(4-methoxystyryl)-s-triazine.

Examples of oxime compounds include 1,2-octanedione, O-acyloxime compounds, 2-(O-benzoyloxime)-1-[4-(phenylthio)phenyl]-1,2-octanedione, 1-(O-acetyloxime)-1-[9-ethyl-6-(2-methylbenzoyl)-9H-carbazol-3-yl]ethanone, and O-ethoxycarbonyl-α-oxyamino-1-phenylpropan-1-one. Specific examples of the O-acyloxime compounds include 2-dimethylamino-2-(4-methylbenzyl)-1-(4-morpholin-4-yl-phenyl)-butan-1-one, 1-(4-phenylsulfanylphenyl)-butane-1,2-dione-2-oxime-O-benzoate, 1-(4-phenylsulfanylphenyl)-octane-1,2-dione-2-oxime-O-benzoate, 1-(4-phenylsulfanylphenyl)-octan-1-one oxime-O-acetate, and 1-(4-phenylsulfanylphenyl)-butan-1-one oxime-O-acetate.

In addition to the above compounds, as the photo-radical generator (B), it is possible to use carbazole compounds, diketone compounds, sulfonium borate compounds, diazo compounds, imidazole compounds, non-imidazole compounds, fluorene compounds, etc.

The photo-radical generator (B) is preferably contained in the range of 0.1 to 10 mass%, more preferably in the range of 0.5 to 6 mass% relative to the total amount of the photosensitive resin composition. When the photo-radical generator is contained within the above range, balance between sensitivity and developability during exposure is excellent and a pattern with excellent resolution can be obtained without residual film. One of the photo-radical generators may be used, or two or more kinds thereof may be used in combination.

### [(C) Polymer in Which Quantum Dot Having Silane Coupling Agent Coordinated is Copolymerized with Alkoxysilane, Alkoxysilane Hydrolysate, or Condensate Thereof]

A quantum dot is a nano-sized semiconductor substance. Atoms form a molecule, and the molecules constitute a small molecular aggregate called "cluster" to form a nanoparticle. When such a nanoparticle particularly exhibits semiconductor properties, it is called a quantum dot (quantum dot particle).

When a quantum dot is excited by receiving external energy, the quantum dot releases energy (emits light) according to corresponding energy band gap by itself (autonomously) .

The quantum dot used in the present invention is not particularly limited and can be used in any form. A quantum dot is mainly a nanoparticle of 10 nm or less, may be a nanowire, a nanorod, a nanotube, a nanocube, or the like, and can be applied in any shape.

The quantum dot used in the present invention can be selected from any suitable materials, for example as semiconductor materials, selected from the group consisting of II-VI group, III-V group, IV group, IV-VI group, I-III-VI group, II-IV-V group, mixed crystals or alloys thereof, and compounds having a perovskite structure. Specific examples thereof include compounds containing ZnS, ZnSe, ZnTe, CdS, CdSe, CdTe, AlN, AlP, AlAs, AlSb, GaN, GaP, GaAs, GaSb, InN, InP, InAs, InSb, Si, Ge, Sn, Pb, PbS, PbSe, PbTe, SnS, SnSe, SnTe, AgGaS₂, AgInS₂, AgGaSe₂, AgInSe₂, CuGaS₂, CuGaSe₂, CuInS₂, CuInSe₂, ZnSiP₂, ZnGeP₂, CdSiP₂, CdGeP₂, CsPbCl₃, CsPbBr₃, CsPbI₃, CsSnCl₃, CsSnBr₃, or CsSnI₃, but not limited thereto.

The quantum dot used in the present invention may have a core-shell structure. Shell materials capable of forming a core-shell structure are not particularly limited, but preferably has a large band gap and low lattice mismatch with respect to the core material, and can be arbitrarily combined according to the core material. Specific examples of the shell material include ZnO, ZnS, ZnSe, ZnTe, CdS, CdSe, CdTe, AlN, AlP, AlAs, AlSb, GaN, GaP, GaAs, GaSb, InN, InP, InAs, InSb, BeS, BeSe, BeTe, MgS, MgSe, MgTe, PbS, PbSe, PbTe, SnS, SnSe, SnTe, CuF, CuCl, CuBr, and CuI. One kind of these materials may be selected, or two or more kinds thereof may be selected as a mixed crystal made of a plurality of materials, and the materials are not limited thereto.

There are various methods for manufacturing the quantum dot used in the present invention, such as a liquid phase method and a vapor phase method, but in the present invention, the methods are not particularly limited. From the viewpoint of exhibiting high fluorescence emission efficiency, it is preferable to use semiconductor nanoparticles obtained using a hot soap method or a hot injection method, in which a precursor species is reacted at high temperature in a nonpolar solvent having a high boiling point. In order to impart dispersibility in a nonpolar solvent and reduce surface flaws, it is desirable that organic ligands are coordinated on the surface.

The organic ligand preferably has an aliphatic hydrocarbon from the viewpoint of dispersibility. Examples of such an organic ligand include oleic acid, stearic acid, palmitic acid, myristic acid, lauric acid, decanoic acid, octanoic acid, oleylamine, stearyl(octadecyl)amine, dodecyl(lauryl)amine, decylamine, octylamine, octadecanethiol, hexadecanethiol, tetradecanethiol, dodecanethiol, decanethiol, octanethiol, trioctylphosphine, trioctylphosphine oxide, triphenylphosphine, triphenylphosphine oxide, tributylphosphine, and tributylphosphine oxide. One kind of the organic ligands may be used, or two or more kinds thereof may be used in combination.

The component (C) preferably has a skeleton having a radically reactive functional group in a surface coating layer of the quantum dot.

The surface of the quantum dot is treated with a silane coupling agent. The silane coupling agent preferably has, as a ligand substituent, at least one of an amino group, a thiol group, a carboxyl group, a phosphino group, a phosphine oxide group, and an ammonium ion. Examples of the silane coupling agent include 3-aminopropyltriethoxysilane, 3-aminopropyltrimethoxysilane, aminophenyltrimethoxysilane, N-(2-aminoethyl)-3-aminopropyltriethoxysilane, 3-mercaptopropyltriethoxysilane, 3-mercaptopropyltrimethoxysilane, 3-mercaptopropyl(dimethoxy)methylsilane, triethoxysilylpropylmaleamic acid, [(3-triethoxysilyl)propyl]succinic anhydride, X-12-1135 (manufactured by Shin-Etsu Chemical Co., Ltd.), diethylphosphatoethyltriethoxysilane, 3-trihydroxypropylmethylphosphonate sodium salt, and trimethyl[3-(trimethoxysilyl)propyl]ammonium chloride.

In one embodiment, the quantum dots surface-treated with a silane coupling agent are copolymerized with a condensate of alkoxysilane or a condensate of alkoxysilane hydrolysate. The copolymerization method is not particularly limited. For example, the surface-treated quantum dot and the condensate of alkoxysilane or the condensate of alkoxysilane hydrolysate are mixed in a mixed solvent of toluene and ethanol, and a small amount of water and a catalyst are added to react them, so that the quantum dots and the condensate of alkoxysilane or the condensate alkoxysilane hydrolysate can be copolymerized. The kind of the catalyst is not particularly limited, and acids and alkalis may be used. Examples of the catalyst include formic acid, hydrochloric acid, nitric acid, acetic acid, aqueous ammonia, and tetramethylammonium hydroxide.

The structure of the condensate of alkoxysilane or the condensate of alkoxysilane hydrolysate is not particularly limited and may be a cage structure, a ladder structure, a random structure, or the like, and may be appropriately selected according to the purpose. A random structure is preferable from the viewpoint of dispersibility and uniformity in the photosensitive resin. The functional group contained in the condensate of alkoxysilane or the condensate of alkoxysilane hydrolysate is not limited and may be appropriately substituted depending on the purpose. Those having an acrylic group or a methacrylic group capable of performing a crosslinking reaction with the photosensitive resin as a substituent are particularly preferable from the viewpoint of improving the patterning properties of resin composition.

In one embodiment, the quantum dots surface-treated with a silane coupling agent are copolymerized with an alkoxysilane or an alkoxysilane hydrolysate. The copolymerization method is not particularly limited. As a synthesis method, a method such as that described in Non-Patent Document 1 is known. For example, the surface-treated quantum dots and alkoxysilane are mixed in a mixed solvent of toluene and ethanol, and a small amount of water and a catalyst are added to react them, thereby to obtain the quantum dot. There are no particular restrictions on the type or amount of the catalyst, and acids or alkalis may be used. Examples of the catalyst include formic acid, hydrochloric acid, nitric acid, acetic acid, aqueous ammonia, and tetramethylammonium hydroxide.

The silane coupling agent is not particularly limited and can be appropriately selected according to the desired resin properties. The silane coupling agent preferably has a vinyl group, an allyl group, a glycidyl group, a phenyl group, an acryl group, a methacryl group, or a thiol group as a functional group. The alkoxysilane to be used may have not only one kind of functional group but also two or more kinds thereof. Examples of the silane coupling agent include trimethoxyvinylsilane, triethoxyvinylsilane, trimethoxy(4-vinylphenyl)silane, allyltriethoxysilane, allyltrimethoxysilane, triethoxy(3-glycidyloxypropyl)silane, 3-glycidyloxypropyltrimethoxysilane, [8-(glycidyloxy)-n-octyl]trimethoxysilane, KBM-573 (manufactured by Shin-Etsu Chemical Co., Ltd.), (3-methacryloyloxypropyl)triethoxysilane, (3-methacryloyloxypropyl)trimethoxysilane, 3-(trimethoxysilyl)propyl acrylate, 3-mercaptopropyltriethoxysilane, and 3-mercaptopropyltrimethoxysilane.

The alkoxysilane may include not only trialkoxysilane but also dialkoxysilane or monoalkoxysilane. The trialkoxysilane, dialkoxysilane, and monoalkoxysilane may have the same functional group or different functional groups. The functional group is not limited and may be appropriately substituted depending on the purpose. Those having an acrylic group or a methacrylic group capable of performing a crosslinking reaction with a photosensitive resin as a substituent are particularly preferable from the viewpoint of improving the patterning properties of the resin composition. By including the dialkoxysilane or the monoalkoxysilane, the degree of crosslinking of the condensate of alkoxysilane or the condensate of alkoxysilane hydrolysate obtained by copolymerization can be controlled; thereby the viscosity of the obtained resin composition can be controlled; and the viscosity can be adjusted according to the manufacturing process. The kind and ratio of these alkoxysilanes are not particularly limited and can be appropriately selected according to the purpose.

The amount of the polymer (C) used in the present invention, in which a quantum dot having a silane coupling agent coordinated is copolymerized with alkoxysilane, alkoxysilane hydrolysate, or condensate thereof, is preferably 5 to 80 mass%, more preferably 10 to 70 mass% of the total amount of the photosensitive resin composition. When the content of the quantum dot particles is within the above range, it is possible to form a fine pattern while maintaining good luminous properties.

### [(D) Surfactant]

The inventive photosensitive resin composition may further contain a surfactant (D) in order to improve coatability.

Examples of the surfactant include polyoxyethylene alkyl ethers, such as polyoxyethylene lauryl ether, polyoxyethylene sterial ether, polyoxyethylene cetyl ether, and polyoxyethylene olein ether; polyoxyethylene alkyl allyl ethers, such as polyoxyethylene octylphenol ether and polyoxyethylene nonylphenol ether; polyoxyethylene polyoxypropylene block copolymers; sorbitan fatty acid esters, such as sorbitan monolaurate, sorbitan monopalmitate, and sorbitan monostearate; nonionic surfactants of polyoxyethylene sorbitan fatty acid esters, such as polyoxyethylene sorbitan monolaurate, polyoxyethylene sorbitan monopalmitate, polyoxyethylene sorbitan monostearate, polyether silicone, polyoxyethylene sorbitan trioleate, and polyoxyethylene sorbitan tristearate; and fluorine-based surfactant, such as EFTOP EF301, EF303 and EF352 (Tohkem Products Co., Ltd.), Megaface F171, F172 and F173 (DIC Corp.), Fluorad FC-4430, FC-430 and FC-431 (Sumitomo 3M Co., Ltd.), Surfynol E1004 (manufactured by Nissin Chemical Industry Co., Ltd.), Asahiguard AG710, Surflon S-381, S-382, SC101, SC102, SC103, SC104, SC105, SC106, KH-10, KH-20, KH-30 and KH-40 (AGC Seimi Chemical Co., Ltd.); organosiloxane polymers KP-341, X-70-092, and X-70-093 (manufactured by Shin-Etsu Chemical Co., Ltd.), and acrylic acid- or methacrylic acid-based Polyflow No. 75 and No. 95 (manufactured by Kyoeisha Chemical Co., Ltd.).

The surfactant (D) is preferably contained in 0.01 to 3 mass%, more preferably 0.02 to 1 mass%, based on the total amount of the photosensitive resin composition. One kind of these surfactants may be used, or two or more kinds thereof may be used in combination.

### [(E) Silane Coupling Agent]

The inventive photosensitive resin composition may further contain a silane coupling agent (E) in order to improve adhesiveness to a substrate.

Examples of silane coupling agents include amino group-containing silane coupling agents, epoxy group-containing silane coupling agents, (meth)acryloyl group-containing silane coupling agents, mercapto group-containing silane coupling agents, vinyl group-containing silane coupling agents, ureido group-containing silane coupling agents, styryl group-containing silane coupling agents, and silane coupling agents having a cyclic anhydride structure. Among these, (meth)acryloyl group-containing silane coupling agents are preferable.

Examples of the amino group-containing silane coupling agent include KBM-602, KBM-603, KBM-903, and KBM-573 (manufactured by Shin-Etsu Chemical Co., Ltd.). Examples of the epoxy group-containing silane coupling agent include KBM-303, KBM-402, KBM-403, and KBE-402 (manufactured by Shin-Etsu Chemical Co., Ltd.). Examples of the (meth)acryloyl group-containing silane coupling agent include KBM-502, KBM-503, KBE-502, KBE-503, and KBM-5103 (manufactured by Shin-Etsu Chemical Co., Ltd.). Examples of the mercapto group-containing silane coupling agent include KBM-802 and KBM-803 (manufactured by Shin-Etsu Chemical Co., Ltd.). Examples of the vinyl group-containing silane coupling agent include KBM-1003 and KBE-1003 (manufactured by Shin-Etsu Chemical Co., Ltd.). Examples of the ureido group-containing silane coupling agent include KBE-585A (manufactured by Shin-Etsu Chemical Co., Ltd.). Examples of the styryl group-containing silane coupling agent include KBM-1403 (manufactured by Shin-Etsu Chemical Co., Ltd.). Examples of a silane coupling agent having a cyclic anhydride structure include X-12-967C (manufactured by Shin-Etsu Chemical Co., Ltd.).

The amount of the silane coupling agent (E) is contained preferably in 0.01 to 5 mass%, more preferably 0.05 to 4 mass%, based on the total amount of the photosensitive resin composition. One kind of these may be used, or two or more kinds thereof may be used in combination.

### [(F) Crosslinking Agent]

The inventive photosensitive resin composition may further contain a crosslinking agent (F). The crosslinking agent is a component that undergoes a crosslinking reaction with the (meth)acryloyl group-containing resin (A) or the surface coating layer of the quantum dots contained in the component (C) and makes it easy to form a pattern having a good shape. Therefore, the crosslinking agent preferably has two or more functions of (meth)acryloyl groups.

Examples of the crosslinking agents having two or more functions of (meth)acryloyl groups include polyfunctional monomer, such as ethylene glycol di(meth)acrylate, diethylene glycol di(meth)acrylate, tetraethylene glycol di(meth)acrylate, propylene glycol di(meth)acrylate, polypropylene glycol di(meth)acrylate, butylene glycol di(meth)acrylate, neopentyl glycol di(meth)acrylate, 1,6-hexane glycol di(meth)acrylate, trimethylolpropane tri(meth)acrylate, glycerin di(meth)acrylate, pentaerythritol triacrylate, pentaerythritol tetraacrylate, dipentaerythritol pentaacrylate, dipentaerythritol hexaacrylate, pentaerythritol di(meth)acrylate, pentaerythritol tri(meth)acrylate, pentaerythritol tetra(meth)acrylate, dipentaerythritol penta(meth) acrylate, dipentaerythritol hexa(meth)acrylate, 2,2-bis(4-(meth)acryloxydiethoxyphenyl)propane, 2,2-bis(4-(meth)acryloxypolyethoxyphenyl) propane, 2-hydroxy-3-(meth)acryloyloxypropyl(meth)acrylate, ethylene glycol diglycidyl ether di(meth)acrylate, diethylene glycol diglycidyl ether di(meth)acrylate, phthalic acid diglycidyl ester di(meth)acrylate, glycerin triacrylate, glycerin polyglycidyl ether poly(meth)acrylate, urethane (meth)acrylate (i.e., a reaction product of tolylene diisocyanate, trimethylhexamethylene diisocyanate, or hexamethylene diisocyanate, or the like, with 2-hydroxyethyl (meth)acrylate), methylene bis(meth)acrylamide, (meth)acrylamide methylene ether, and condensate of polyhydric alcohol and N-methylol (meth)acrylamide; and triacrylformal.

The crosslinking agent (F) is preferably contained in an amount of 0.5 to 100 parts by mass, and more preferably 1 to 50 parts by mass, based on 100 parts by mass of the component (A). One kind of these may be used, or two or more thereof may be used in combination.

### [(G) Solvent]

The inventive photosensitive resin composition may contain a solvent as the component (G). The solvent (G) is not particularly limited as long as it can dissolve and disperse the above-mentioned components (A) to (F) and various other additives.

The solvent (G) is preferably an organic solvent. Specific examples thereof include ketones, such as cyclohexanone, cyclopentanone, and methyl-2-n-pentyl ketone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters, such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, propylene glycol-mono-tert-butyl ether acetate, and γ-butyrolactone. One kind of these may be used, or two or more thereof may be used in a mixture.

As the solvent (G), propylene glycol monomethyl ether acetate, propylene glycol monomethyl ether, cyclopentanone, and mixed solvents thereof are preferable, which have particularly excellent solubility of the (meth)acryloyl group-containing resin (A) and the photo-radical generator (B).

The component (G) is preferably contained in 25 to 85 mass%, more preferably 35 to 75 mass% of the total amount of the photosensitive resin composition, from the viewpoint of compatibility and viscosity of the photosensitive resin composition.

### [Photosensitive Resin Film]

The inventive photosensitive resin film is a dried product of the photosensitive resin composition described above.

### [Patterning Process Using Photosensitive Resin Composition]

The patterning process using the inventive photosensitive resin composition includes steps of:
(i) applying the photosensitive resin composition described above onto a substrate to form a photosensitive resin film on the substrate;
(ii) exposing the photosensitive resin film to light; and
(iii) developing the exposed photosensitive resin film with a developer to dissolve and remove an unexposed portion, thereby to form a pattern.

The step (i) is a step in which the photosensitive resin composition described above is applied onto a substrate to form a photosensitive resin film on the substrate. The photosensitive resin film is a dried product of the photosensitive resin composition described above. Examples of the substrate include a silicon wafer, a glass wafer, a quartz wafer, a plastic circuit substrate, and a ceramic circuit substrate.

The application method may be a publicly known method, and the examples thereof include a dipping method, a spin-coating method, and a roll-coating method. The amount to be applied can be appropriately selected in accordance with the purpose, but the application is performed so that the obtained photosensitive resin film (the dried product of the photosensitive resin composition) has preferably a thickness of 0.1 to 200 µm, more preferably 1 to 150 µm.

In this case, the solvent or the like may be evaporated in advance by pre-heating (pre-baking) as necessary for efficient photocuring reaction. The pre-baking may be performed, for example, at 40 to 140°C for about 1 minute to 1 hour.

Then, (ii) the photosensitive resin film is exposed to light. In this event, the exposure is preferably performed with light having a wavelength of 10 to 600 nm, more preferably performed with light having a wavelength of 190 to 500 nm. The light having such wavelengths are, for example, light having various wavelengths generated from a radiation-beam generating instrument. Examples of the light include ultraviolet light, such as a g-line, an h-line, and an i-line; and far ultraviolet light (248 nm, 193 nm). Among these, light with a wavelength of 248 to 436 nm is particularly preferable. The exposure dose is preferably 10 to 10,000 mJ/cm².

The exposure may be performed via a photomask. The photomask may have a desired pattern by boring, for example. Incidentally, materials of the photomask are not particularly limited, but are preferably those blocks light having the aforementioned wavelength. For example, a photomask containing chromium is suitably used as a light-blocking film, but is not limited thereto.

(iii) The exposed photosensitive resin film is developed with a developer after the exposure to form a pattern. The developers are preferably, for example, organic solvents, such as alcohols including IPA; ketones including cyclohexanone; and glycols including propylene glycol monomethyl ether; or publicly known alkaline developers typically represented by an aqueous solution of tetramethylammonium hydroxide or the like. Examples of the development method may be common methods. Examples thereof include a dip method in which a patterned substrate is soaked in a developer, a puddle method in which a developer is dispensed with a paddle, and a spray method in which a developer is sprayed with a spray. By the development according to these methods, an unexposed portion is dissolved and removed, and a pattern is formed. Then, as necessary, washing, rinsing, drying, and the like are carried out to obtain a cured film having a desired pattern.

The patterning processes using the inventive photosensitive resin composition make it possible to easily form a fine pattern. For example, light in red and green can be also emitted thanks to forming a cured film containing red quantum dots and green quantum dots in each segment on a blue micro-LED by: forming a film by using the inventive photosensitive resin composition so that the film covers numerous blue micro-LEDs paving a substrate; and next performing a fine patterning. Thus, it becomes possible to produce a light emitting device capable of representing full color.

### [Light Emitting Device]

The inventive light emitting device includes a cured film obtained by the patterning process described above. That is, the inventive light-emitting device includes a cured film in which a pattern is formed in the above-described photosensitive resin film.

### EXAMPLE

Hereinafter, the present invention will be specifically described with reference to Synthesis Examples, Examples, and Comparative Examples. However, the present invention is not limited thereto. Incidentally, a quantum dot of an InP/ZnSe/ZnS core-shell type is used as a quantum dot material. The synthesis methods for the core are as shown below in [1-1] (red quantum dot) and [1-2] (green quantum dot), and the subsequent synthesis method for the shell is as shown in [2].

### [1-1] Synthesis Process of Red Quantum Dot Core

Two flasks were prepared, and 0.23 g (0.9 mmol) of palmitic acid, 0.088 g (0.3 mmol) of indium acetate, and 10 mL of 1-octadecene were added to each flask. The mixtures were heated and stirred at 100°C under reduced pressure, and degassed for 1 hour while dissolving the materials. Then, nitrogen was purged into the two flasks, and 0.75 mL (0.15 mmol) of tristrimethylsilylphosphine/trioctylphosphine solution (0.2 M) was added to both flasks. Then, one of the flasks was heated to 300°C, and it was confirmed that core particles were formed by observing the solution turned from yellow to red. The solution was drawn from the flask that had not been heated and then added gradually to the flask that had been heated to 300°C, thereby to adjust so that the core particle had a desired particle size.

### [1-2] Synthesis Process of Green Quantum Dot Core

0.23 g (0.9 mmol) of palmitic acid, 0.088 g (0.3 mmol) of indium acetate, and 10 mL of 1-octadecene were added to a flask, and the mixture was heated and stirred at 100°C under reduced pressure, and degassed for 1 hour while dissolving the materials. Then, nitrogen was purged into the flask, and 0.75 mL (0.15 mmol) of a solution prepared by mixing tristrimethylsilylphosphine with trioctylphosphine to give a 0.2 M solution was added thereto; the temperature was raised to 300°C; and it was confirmed that core particles were formed by observing the solution turned from yellow to red.

### [2] Synthesis Process of Quantum Dot Shell

Next, 2.85 g (4.5 mmol) of zinc stearate and 15 mL of 1-octadecene were added to another flask, and the mixture was heated and stirred at 100°C under reduced pressure, and degassed for 1 hour while dissolving the zinc stearate, thereby to prepare a 0.3 M zinc stearate octadecene solution. 3.0 mL (0.9 mmol) of the 0.3 M zinc stearate octadecene solution was added to the reacted solution having the core synthesized and the resultant mixture was cooled to 200°C. Next, 0.474 g (6 mmol) of selenium and 4 mL of trioctylphosphine were added to another flask, and the mixture was heated to 150°C for dissolving them, thereby to prepare a 1.5 M selenium trioctylphosphine solution. While increasing the temperature of the reacted solution after the core synthesis process, which had been cooled to 200°C, to 320°C over 30 minutes, the reacted solution was added with the selenium trioctylphosphine solution in 0.1 mL increments to a total of 0.6 mL (0.9 mmol), maintained at 320°C for 10 minutes, and then cooled to room temperature. 0.44 g (2.2 mmol) of zinc acetate was added thereto and dissolved by heating and stirring at 100°C under reduced pressure. The flask was purged again with nitrogen and heated to 230°C, added with 0.98 mL (4 mmol) of 1-dodecanethiol, and held for 1 hour. The obtained solution was cooled to room temperature to prepare a solution containing core-shell type quantum dots. The red core-shell type quantum dot-containing solution synthesized through the processes from [1-1] to [2] is designated R-1, and the green core-shell type quantum dot-containing solution synthesized through the processes from [1-2] to [2] is designated G-1.

### [3] Surface Treatment Process

After the reaction was completed, the reacted solution was cooled to room temperature, and was added with ethanol to make precipitate in the reacted solution, which was then centrifuged to remove the supernatant. The same purification process was repeated again, and the resultant was dispersed in toluene. The toluene solution of the quantum dots was placed in a flask of which content is replaced with nitrogen. 0.24 mL (1.0 mmol) of (3-mercaptopropyl)triethoxysilane was added thereto and stirred at room temperature for 24 hours to perform surface treatment. The quantum dots surface-treated with R-1 were designated R-2, and the quantum dots surface-treated with G-1 were designated G-2.

### [4] Condensation Process of Alkoxysilane or Alkoxysilane Hydrolysate

10 mL of 3-(methacryloyloxy)propyltrimethoxysilane, 20 mL of toluene, and 10 mL of methanol were mixed in a flask of which content is replaced with nitrogen, and 4.0 mL of 1.0 N hydrochloric acid was added dropwise little by little while stirring at room temperature. After the dropwise addition, the mixture was stirred at room temperature for 60 minutes, and the solution temperature was increased to 60°C and refluxed to be reacted for 60 minutes. The system was then evacuated for 2 hours at 60°C to distill off the solvent. A condensate of alkoxysilane or a condensate of alkoxysilane hydrolysate having a methacryl group was obtained in the flask.

### [5] Copolymerization of Quantum Dot with Condensate of Alkoxysilane or Condensate of Alkoxysilane Hydrolysate

The condensate of alkoxysilane or the condensate of alkoxysilane hydrolysate, which was obtained in the flask after the nitrogen replacement, and the surface-treated quantum dot solution obtained in [3] were mixed so that the solid content concentration was 20 mass%, and 20 mL of toluene and 10 mL of methanol were further added and mixed. 4.0 mL of 1.0 N hydrochloric acid was added dropwise thereto little by little while stirring at room temperature. After the dropwise addition, the mixture was stirred at room temperature for 60 minutes; the solution temperature was then increased to 60°C; and the mixture was further allowed to react for 60 minutes under reflux. Thereafter, PGMEA was added thereto, and the toluene solvent was removed by distillation under reduced pressure, thereby to obtain a copolymer of the quantum dots and the condensate of alkoxysilane or the condensate of alkoxysilane hydrolysate. A copolymer of R-2 and the condensate of alkoxysilane or the condensate of alkoxysilane hydrolysate is designated R-3, and a condensate of G-2 and the alkoxysilane or the alkoxysilane hydrolysate is designated G-3.

### [6] Copolymerization of Quantum Dot with Alkoxysilane or Alkoxysilane Hydrolysate

7 mL of 3-(methacryloyloxy)propyltrimethoxysilane, 3 mL of ethoxytrimethylsilane, and the surface-treated quantum dot solution obtained in [3] were added to a flask of which content is replaced with nitrogen so that the solid content concentration was 20 mass%, and 20 mL of toluene and 10 mL of methanol were further added thereto and mixed. 4.0 mL of 1.0 N hydrochloric acid was added dropwise thereto little by little while stirring at room temperature. After the dropwise addition, the mixture was stirred at room temperature for 60 minutes; the solution temperature was then increased to 60°C; and the mixture was further allowed to react for 60 minutes under reflux. Thereafter, PGMEA was added thereto, and the toluene solvent was removed by distillation under reduced pressure, thereby to obtain a copolymer of the quantum dots and the alkoxysilane or the alkoxysilane hydrolysate. A copolymer of R-2 and the alkoxysilane or the alkoxysilane hydrolysate is designated R-4, and a copolymer of G-2 and the alkoxysilane or the alkoxysilane hydrolysate is designated G-4.

### [7] Preparation and Evaluation of Photosensitive Resin Composition

### [Examples 1 to 16 and Comparative Examples 1 to 24]

Each component was blended according to the blending amounts shown in Tables 1 to 4, then the mixture was mixed and stirred at room temperature, and microfiltered through a 1.0 µm glass filter to obtain the photosensitive resin compositions of Examples 1 to 16 and Comparative Examples 1 to 24.

**[Table 1]**

| Component | | | Example | | | | | | | |
|---|---|---|---|---|---|---|---|---|---|---|
| | | | 1 | 2 | 3 | 4 | 5 | 6 | 7 | 8 |
| A | Resin | RA-4101 | 100 | | | | 100 | | | |
| | | RA-3631P | | 100 | | | | 100 | | |
| | | 8KQ-2001 | | | 100 | | | | 100 | |
| | | 8KQ-7052 | | | | 100 | | | | 100 |
| B | Photo-radical generator | Irgacure 184 | 5 | | 5 | | 10 | | 15 | |
| | | Irgacure OXE01 | | 5 | | 5 | | 10 | | 15 |
| C | Quantum dot | R-3 | 15 | | 30 | | 100 | | 380 | |
| | | R-4 | | 15 | | 30 | | 100 | | 380 |
| D | Surfactant | KP-341 | | | | | 0.5 | 0.5 | 3 | 3 |
| E | Silane coupling agent | KBM-503 | | | 1 | 1 | 5 | 5 | 20 | 20 |
| F | Crosslinking agent | M-940 | | | 5 | | 10 | | 30 | |
| | | DPCA-20 | | | | 5 | | 20 | | 50 |
| G | Solvent | PGMEA | 120 | 120 | 141 | 141 | 226 | 236 | 548 | 568 |

**[Table 2]**

| Component | | | Example | | | | | | | |
|---|---|---|---|---|---|---|---|---|---|---|
| | | | 9 | 10 | 11 | 12 | 13 | 14 | 15 | 16 |
| A | Resin | RA-4101 | 100 | | | | 100 | | | |
| | | RA-3631P | | 100 | | | | 100 | | |
| | | 8KQ-2001 | | | 100 | | | | 100 | |
| | | 8KQ-7052 | | | | 100 | | | | 100 |
| B | Photo-radical generator | Irgacure 184 | 5 | | 5 | | 10 | | 15 | |
| | | Irgacure OXE01 | | 5 | | 5 | | 10 | | 15 |
| C | Quantum dot | G-3 | 15 | | 30 | | 100 | | 380 | |
| | | G-4 | | 15 | | 30 | | 100 | | 380 |
| D | Surfactant | KP-341 | | | | | 0.5 | 0.5 | 3 | 3 |
| E | Silane coupling agent | KBM-503 | | | 1 | 1 | 5 | 5 | 20 | 20 |
| F | Crosslinking agent | M-940 | | | 5 | | 10 | | 30 | |
| | | DPCA-20 | | | | 5 | | 20 | | 50 |
| G | Solvent | PGMEA | 120 | 120 | 141 | 141 | 226 | 236 | 548 | 568 |

**[Table 3]**

| Component | | | Comparative Example | | | | | | | | | | | |
|---|---|---|---|---|---|---|---|---|---|---|---|---|---|---|
| | | | 1 | 2 | 3 | 4 | 5 | 6 | 7 | 8 | 9 | 10 | 11 | 12 |
| A | Resin | RA-4101 | 100 | | | | 100 | | | | 100 | | | |
| | | RA-3631P | | 100 | | | | 100 | | | | 100 | | |
| | | 8KQ-2001 | | | 100 | | | | 100 | | | | 100 | |
| | | 8KQ-7052 | | | | 100 | | | | 100 | | | | 100 |
| B | Photo-radical generator | Irgacure 184 | 5 | 5 | | | 10 | 10 | | | 15 | 15 | | |
| | | Irgacure OXE01 | | | 5 | 5 | | | 10 | 10 | | | 15 | 15 |
| C | Quantum dot | R-1 | 15 | | | | 100 | | | | 380 | | | |
| | | R-2 | | 15 | | | | 100 | | | | 380 | | |
| | | R-5 | | | 15 | | | | 100 | | | | 380 | |
| | | R-6 | | | | 15 | | | | 100 | | | | 380 |
| D | Surfactant | KP-341 | | | | | 0.5 | 0.5 | 0.5 | 0.5 | 3 | 3 | 3 | 3 |
| E | Silane coupling agent | KBM-503 | | | | | 1 | 1 | 5 | 5 | 20 | 20 | 10 | 10 |
| F | Crosslinking agent | M-940 | | | | | 5 | | 20 | | 30 | | 50 | |
| | | DPCA-20 | | | | | | 5 | | 20 | | 30 | | 50 |
| G | Solvent | PGMEA | 120 | 120 | 120 | 120 | 217 | 217 | 236 | 236 | 548 | 548 | 558 | 558 |

**[Table 4]**

| Component | | | Comparative Example | | | | | | | | | | | |
|---|---|---|---|---|---|---|---|---|---|---|---|---|---|---|
| | | | 13 | 14 | 15 | 16 | 17 | 18 | 19 | 20 | 21 | 22 | 23 | 24 |
| A | Resin | RA-4101 | 100 | | | | 100 | | | | 100 | | | |
| | | RA-3631P | | 100 | | | | 100 | | | | 100 | | |
| | | 8KQ-2001 | | | 100 | | | | 100 | | | | 100 | |
| | | 8KQ-7052 | | | | 100 | | | | 100 | | | | 100 |
| B | Photo-radical generator | Irgacure 184 | 5 | 5 | | | 10 | 10 | | | 15 | 15 | | |
| | | Irgacure OXE01 | | | 5 | 5 | | | 10 | 10 | | | 15 | 15 |
| C | Quantum dot | G-1 | 15 | | | | 100 | | | | 380 | | | |
| | | G-2 | | 15 | | | | 100 | | | | 380 | | |
| | | G-5 | | | 15 | | | | 100 | | | | 380 | |
| | | G-6 | | | | 15 | | | | 100 | | | | 380 |
| D | Surfactant | KP-341 | | | | | 0.5 | 0.5 | 0.5 | 0.5 | 3 | 3 | 3 | 3 |
| E | Silane coupling agent | KBM-503 | | | | | 1 | 1 | 5 | 5 | 20 | 20 | 10 | 10 |
| F | Crosslinking agent | M-940 | | | | | 5 | | 20 | | 30 | | 50 | |
| | | DPCA-20 | | | | | | 5 | | 20 | | 30 | | 50 |
| G | Solvent | PGMEA | 120 | 120 | 120 | 120 | 217 | 217 | 236 | 236 | 548 | 548 | 558 | 558 |

In Tables 1 to 4, the resins are: acrylic resins manufactured by Negami Kogyo Co., having product names of "RA-4101" (Mw: 30,000 g/mol, acid value: 90 mgKOH/g, and double bond equivalent: 350 g/mol) and "RA-3631P" (Mw: 18,000 g/mol, acid value: 5 mgKOH/g, and double bond equivalent: 250 g/mol); and acrylic resins manufactured by Taisei Fine Chemical Co., having product names of "8KQ-2001" (Mw: 20,000 g/mol, acid value: 130 mgKOH/g, and double bond equivalent: 540 g/mol) and "8KQ-7052" (Mw: 19,000 g/mol, acid value: 7 mgKOH/g, and double bond equivalent: 500 g/mol.

In Tables 1 to 4, the photo-radical generators are those manufactured by BASF, having product names of "Irgacure 184" (1-hydroxycyclohexyl-phenyl ketone) and "Irgacure OXE01".

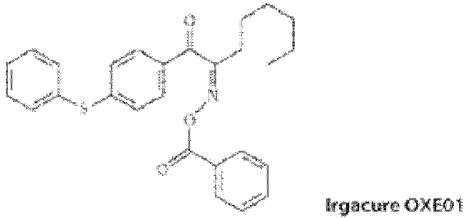

In Tables 1 to 4, the surfactant is manufactured by Shin-Etsu Chemical Co., Ltd., having a product name of "KP-341" polyether type siloxane.

In Tables 1 to 4, the silane coupling agent is manufactured by Shin-Etsu Chemical Co., Ltd., having a product name of "KBM-503" (3-methacryloxypropyltrimethoxysilane).

In Tables 1 to 4, the crosslinking agents are: those manufactured by Toagosei Co., Ltd., having a product name of "Aronix (registered trademark) M-940" (dipentaerythritol hexaacrylate); and those manufactured by Nippon Kayaku Co., Ltd., having a product name of "DPCA-20".

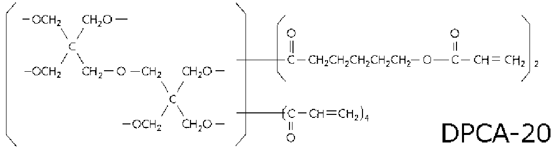

In Tables 1 to 4, for the quantum dots, R-5 is S-BE030 (particle size: 5 to 10 nm, material: InP:ZnS:SeZn = 25:50:25) manufactured by Shoei Chemical Inc.; R-6 is 900514-1ML (particle size: 5 to 10 nm, material: CdSe (core) / CdS (shell) core-shell type) manufactured by Aldrich; G-5 is S-BE029 (particle size: 3 to 5 nm, material: InP:ZnS:SeZn = 25:50:25) manufactured by Shoei Chemical Inc.; and G-6 is 900511-1ML (particle size: 3 to 5 nm, material: CdSe (core) / CdS (shell) core-shell type) manufactured by Aldrich.

### [8] Evaluation of Photosensitive Resin Film

### (1) Checking Presence of Aggregate in Film

A silicon wafer was coated with each of the photosensitive resin composition respectively to have a film thickness of 20 µm with a spin-coater. In order to remove solvents from the composition, the substrate was heated and dried on a hotplate at 110°C for 4 minutes. Presence of aggregate in the obtained photosensitive resin films was checked with an optical microscope. A sample having an aggregate with a size of 1 µm or more in a 10 mm × 10 mm area was judged "Bad", and a sample having no aggregate or an aggregate with a size of less than 1 µm was judged "Good". The results are shown in Tables 5 to 8.

### (2) Formation and Evaluation of Pattern Forming

In order to form a square island pattern having a pitch distance of 1:1 to an adjacent pattern in the obtained photosensitive resin film through a mask, the obtained photosensitive resin film was exposed to light using an i-line stepper NSR-2205i11D (manufactured by Nikon Corporation). After the exposure, when a sample was for the case that the sequential number of Example or Comparative Example was odd, a pattern was formed, by paddle development for 90 seconds using 2.38% aqueous solution of tetramethylammonium hydroxide. When a sample was for the case that the sequential number of Example or Comparative Example was even, a pattern was formed by paddle development for 90 seconds using PGMEA after the exposure. Thereafter, the formed island patterns having a side of 50 µm, 40 µm, 30 µm, 20 µm, and 10 µm were observed with a scanning electron microscope (SEM), and the size of the smallest pattern that was not connected to the adjacent island pattern (pitch distance 1:1) was defined as limit resolution. When the resolution of a sample did not reach 50 µm or a pattern of a sample was peeled off during development, the sample was judged as "Bad". The results are shown in Tables 5 to 8.

### (3) Evaluation of Luminous Properties of Formed Pattern

Using LabRAM HR Evolution manufactured by Horiba Techno Service Co., Ltd., the patterned sample prepared in (2) above was irradiated with laser beam (0.03 mW) having a wavelength of 457 nm, the photoconverted island pattern area was measured for emission intensity, emission wavelength, and half band width of the photoconverted light. In addition, the samples after the heating and drying process, which were prepared in (1) above, was also measured similarly for the emission intensity of the photoconverted light. The results are shown in Tables 5 to 8 ("M" represents 1 million).

### (4) Reliability Test and Evaluation

The patterned measurement samples of (2) above were subjected to a laser light resistance test by continuing to have the samples irradiated with Laser of 454 nm and 1 W in an oven set at 85°C. The emission intensity of the photoconverted light were measured before and after the test in the same manner as in (3), and a change rate (rate of decrease) from the initial state was confirmed (Change rate = ((emission intensity after test/ emission intensity before test) - 1) × 100). The results are shown in Tables 5 to 8.

### (5) Adhesiveness Test and Evaluation

A silicon wafer was coated with the photosensitive resin composition shown in Tables 1 to 4 at a film thickness of 50 µm using a spin coater. In order to remove the solvent from the composition, the substrate was placed on a hot plate and dried by heating at 110°C for 10 minutes. All the surface of the obtained photosensitive resin film was exposed to light using a contact aligner type exposure apparatus under exposure conditions of 365 nm to be cured. A cross-cut peel test (JIS K 5400) was performed to evaluate the adhesiveness to the substrate. The number of cross-cut pieces that peeled off out of 100 cross-cut pieces is shown in Tables 5 to 8.

**[Table 5]**

| | | Example | | | | | | | |
|---|---|---|---|---|---|---|---|---|---|
| | | 1 | 2 | 3 | 4 | 5 | 6 | 7 | 8 |
| Checking Presence of Aggregate | | Good | Good | Good | Good | Good | Good | Good | Good |
| Limit resolution of patterning / µm | | 10 | 10 | 5 | 5 | 10 | 10 | 10 | 10 |
| Emission intensity after heating and drying | | 20M | 21M | 34M | 35M | 71M | 68M | 111M | 107M |
| Luminous properties of pattern in cured film | Wavelength / nm | 623 | 624 | 623 | 624 | 626 | 625 | 626 | 625 |
| | Half band width / nm | 41 | 42 | 41 | 43 | 44 | 43 | 43 | 44 |
| | Emission intensity | 20M | 21M | 34M | 35M | 71M | 68M | 111M | 107M |
| Change in emission intensity after reliability test / % | | -5 | -5 | -4 | -4 | -2 | -1 | -2 | -2 |
| Number of separations in cross-cut test | | 0 | 0 | 0 | 0 | 0 | 0 | 0 | 0 |

**[Table 6]**

| | | Example | | | | | | | |
|---|---|---|---|---|---|---|---|---|---|
| | | 9 | 10 | 11 | 12 | 13 | 14 | 15 | 16 |
| Checking Presence of Aggregate | | Good | Good | Good | Good | Good | Good | Good | Good |
| Limit resolution of patterning / µm | | 10 | 10 | 5 | 5 | 10 | 10 | 10 | 10 |
| Emission intensity after heating and drying | | 17M | 16M | 28M | 27M | 57M | 58M | 89M | 86M |
| Luminous properties of pattern in cured film | Wavelength / nm | 533 | 534 | 534 | 534 | 537 | 536 | 536 | 536 |
| | Half band width / nm | 37 | 36 | 37 | 37 | 39 | 38 | 39 | 40 |
| | Emission intensity | 17M | 16M | 28M | 27M | 57M | 58M | 89M | 86M |
| Change in emission intensity after reliability test / % | | -5 | -4 | -5 | -5 | -2 | -2 | -1 | -2 |
| Number of separations in cross-cut test | | 0 | 0 | 0 | 0 | 0 | 0 | 0 | 0 |

**[Table 7]**

| | | Comparative Example | | | | | | | | | | | |
|---|---|---|---|---|---|---|---|---|---|---|---|---|---|
| | | 1 | 2 | 3 | 4 | 5 | 6 | 7 | 8 | 9 | 10 | 11 | 12 |
| Checking Presence of Aggregate | | Bad | Bad | Bad | Bad | Bad | Bad | Bad | Bad | Bad | Bad | Bad | Bad |
| Limit resolution of patterning / µm | | 50 | 50 | 50 | 50 | 50 | 50 | 50 | 50 | Bad | Bad | Bad | Bad |
| Emission intensity after heating and drying | | 6M | 5M | 6M | 5M | 22M | 21M | 20M | 19M | 33M | 33M | 31M | 32M |
| Luminous properties of pattern in cured film | Wavelength / nm | 636 | 635 | 636 | 636 | 638 | 637 | 638 | 637 | 640 | 639 | 641 | 641 |
| | Half band width / nm | 54 | 53 | 53 | 53 | 55 | 56 | 54 | 54 | 56 | 55 | 58 | 56 |
| | Emission intensity | 4M | 3M | 4M | 3M | 12M | 12M | 13M | 12M | 17M | 17M | 17M | 18M |
| Change in emission intensity after reliability test / % | | -63 | -58 | -51 | -56 | -71 | -68 | -75 | -62 | -80 | -88 | -83 | -82 |
| Number of separations in cross-cut test | | 100 | 100 | 100 | 100 | 100 | 100 | 100 | 100 | 100 | 100 | 100 | 100 |

**[Table 8]**

| | | Comparative Example | | | | | | | | | | | |
|---|---|---|---|---|---|---|---|---|---|---|---|---|---|
| | | 13 | 14 | 15 | 16 | 17 | 18 | 19 | 20 | 21 | 22 | 23 | 24 |
| Checking Presence of Aggregate | | Bad | Bad | Bad | Bad | Bad | Bad | Bad | Bad | Bad | Bad | Bad | Bad |
| Limit resolution of patterning / µm | | 50 | 50 | 50 | 50 | 50 | 50 | 50 | 50 | Bad | Bad | Bad | Bad |
| Emission intensity after heating and drying | | 4M | 4M | 3M | 4M | 15M | 14M | 13M | 13M | 21M | 22M | 21M | 20M |
| Luminous properties of pattern in cured film | Wavelength / nm | 541 | 540 | 541 | 542 | 543 | 544 | 544 | 546 | 547 | 547 | 547 | 548 |
| | Half band width / nm | 53 | 54 | 53 | 54 | 56 | 58 | 57 | 56 | 58 | 60 | 59 | 59 |
| | Emission intensity | 2M | 2M | 2M | 2M | 8M | 8M | 8M | 7M | 13M | 12M | 12M | 13M |
| Change in emission intensity after reliability test / % | | -58 | -63 | -55 | -59 | -74 | -69 | -76 | -62 | -85 | -90 | -85 | -86 |
| Number of separations in cross-cut test | | 100 | 100 | 100 | 100 | 100 | 100 | 100 | 100 | 100 | 100 | 100 | 100 |

From the above results, the inventive photosensitive resin composition was shown to: be able to form a good photosensitive resin film having no aggregate (or having very small aggregates if any); have high lithography resolution, high luminous properties that do not change after the lithography process, favorable reliability (low change rate in emission intensity shown in the laser light resistance test), and high adhesiveness to a base material; and be able to provide a cured film suitable for a light emitting device.

On the other hand, in Comparative Examples 1, 2, 5, 6, 9, 10, 13, 14, 17, 18, 21, and 22 in which the used quantum dots as the component (C) were R-1, R-2, G-1, or G-2, which were not copolymerized with alkoxysilane, alkoxysilane hydrolysate, or condensate thereof, aggregate was confirmed to be exist, and thus a good photosensitive resin film could not be formed: the photosensitive resin composition is inferior in lithography resolution, luminous properties before and after the lithography process, change rate in emission intensity in the laser light resistance test, and adhesiveness to a base material when compared to the inventive photosensitive resin composition; and their cured films were not suitable for a light emitting device.

Similarly, in Comparative Examples 3, 4, 7, 8, 11, 12, 15, 16, 19, 20, 23, and 24 in which commercially available quantum dots R-5, R-6, G-5, and G-6 were used as the component (C), aggregate was confirmed to be exist, and thus a good photosensitive resin film could not be formed: the photosensitive resin composition is inferior in lithography resolution, luminous properties before and after the lithography process, change rate in emission intensity in the laser light resistance test, and adhesiveness to a base material when compared to the inventive photosensitive resin composition; and their cured films were not suitable for a light emitting device.

The present description includes the following embodiments.
[1]: A photosensitive resin composition comprising:
   (A) a (meth)acryloyl group-containing resin;
   (B) a photo-radical generator; and
   (C) a polymer in which a quantum dot having a silane coupling agent coordinated is copolymerized with alkoxysilane, alkoxysilane hydrolysate, or condensate thereof.
[2]: The photosensitive resin composition according to the above [1], wherein the component (C) has a skeleton having a radically reactive functional group in a surface coating layer of the quantum dot.
[3]: The photosensitive resin composition according to the above [1] or [2], wherein the component (C) has any one or more kinds of an amino group, a thiol group, a carboxy group, a phosphino group, a phosphine oxide group, or an ammonium ion, as a ligand substituent of the silane coupling agent.
[4]: The photosensitive resin composition according to any one of the above [1] to [3], wherein the component (C) is contained in 5 to 80 mass% of the photosensitive resin composition.
[5]: The photosensitive resin composition according to any one of the above [1] to [4], wherein the component (A) has a double bond equivalent of 240 to 1,000 g/mol.
[6]: The photosensitive resin composition according to any one of the above [1] to [5], wherein the component (A) is an acrylic resin having a weight-average molecular weight of 5,000 to 100,000 g/mol.
[7]: The photosensitive resin composition according to any one of the above [1] to [6], further comprising (D) a surfactant.
[8]: The photosensitive resin composition according to any one of the above [1] to [7], further comprising (E) a silane coupling agent.
[9]: The photosensitive resin composition according to any one of the above [1] to [8], further comprising a crosslinking agent (F) having 2 or more functions of (meth)acryloyl groups.
[10]: The photosensitive resin composition according to any one of the above [1] to [9], further comprising (G) a solvent.
[11]: A photosensitive resin film comprising a dried product of the photosensitive resin composition according to any one of the above [1] to [10].
[12]: A patterning process comprising steps of:
   (i) applying the photosensitive resin composition according to any one of the above [1] to [10] onto a substrate to form a photosensitive resin film on the substrate;
   (ii) exposing the photosensitive resin film to light; and
   (iii) developing the exposed photosensitive resin film with a developer to dissolve and remove an unexposed portion, thereby to form a pattern.
[13]: A light emitting device comprising a cured film having a pattern formed in the photosensitive resin film according to the above [11].

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A photosensitive resin composition comprising:
(A) a (meth)acryloyl group-containing resin;
(B) a photo-radical generator; and
(C) a polymer in which a quantum dot having a silane coupling agent coordinated is copolymerized with alkoxysilane, alkoxysilane hydrolysate, or condensate thereof.

2. The photosensitive resin composition according to claim **1,** wherein the component (C) has a skeleton having a radically reactive functional group in a surface coating layer of the quantum dot.

3. The photosensitive resin composition according to claim 1, wherein the component (C) has any one or more kinds of an amino group, a thiol group, a carboxy group, a phosphino group, a phosphine oxide group, or an ammonium ion, as a ligand substituent of the silane coupling agent.

4. The photosensitive resin composition according to claim 1, wherein the component (C) is contained in 5 to 80 mass% of the photosensitive resin composition.

5. The photosensitive resin composition according to claim 1, wherein the component (A) has a double bond equivalent of 240 to 1,000 g/mol.

6. The photosensitive resin composition according to claim 1, wherein the component (A) is an acrylic resin having a weight-average molecular weight of 5,000 to 100,000 g/mol.

7. The photosensitive resin composition according to claim 1, further comprising (D) a surfactant.

8. The photosensitive resin composition according to claim 1, further comprising (E) a silane coupling agent.

9. The photosensitive resin composition according to claim 1, further comprising a crosslinking agent (F) having 2 or more functions of (meth)acryloyl groups.

10. The photosensitive resin composition according to claim 1, further comprising (G) a solvent.

11. A photosensitive resin film comprising a dried product of the photosensitive resin composition according to any one of claims 1 to 10.

12. A patterning process comprising steps of:
(i) applying the photosensitive resin composition according to any one of claims 1 to 10 onto a substrate to form a photosensitive resin film on the substrate;
(ii) exposing the photosensitive resin film to light; and
(iii) developing the exposed photosensitive resin film with a developer to dissolve and remove an unexposed portion, thereby to form a pattern.

13. A light emitting device comprising a cured film having a pattern formed in the photosensitive resin film according to claim 11.
